Europäisches Patentamt

**European Patent Office**

Office européen des brevets

(11) Veröffentlichungsnummer: **0 007 122**
**B1**

(12) # EUROPÄISCHE PATENTSCHRIFT

(45) Veröffentlichungstag der Patentschrift:
**08.04.81**

(51) Int. Cl.³: **H 05 K 7/20,** H 04 Q 1/04

(21) Anmeldenummer: **79200322.0**

(22) Anmeldetag: **20.06.79**

(54) **Zwangsbelüftetes Elektronikgestell.**

(30) Priorität: **14.07.78 CH 7650/78**

(43) Veröffentlichungstag der Anmeldung:
**23.01.80 Patentblatt 80/2**

(45) Bekanntmachung des Hinweises auf die Patenterteilung:
**08.04.81 Patentblatt 81/14**

(84) Benannte Vertragsstaaten:
**AT BE DE FR GB IT NL SE**

(56) Entgegenhaltungen:
**DE-A-2 638 118**
**FR-A-2 193 303**
**US-A-2 774 808**

(73) Patentinhaber: **Hasler AG, Belpstrasse 23,
CH-3000 Bern 14 (CH)**

(72) Erfinder: **Schindler, Kurt, Werdtweg 19, CH-3007 Bern
(CH)**

(74) Vertreter: **Schwerdtel, Eberhard, c/o Hasler AG
Belpstrasse 23, CH-3000 Bern 14 (CH)**

BUNDESDRUCKEREI BERLIN

## Zwangsbelüftetes Elektronikgestell

Die Erfindung betrifft ein etagenweise, mit einem Zwangslüftungssystem ausgestattetes Elektronikgestell zur Aufnahme einer Vielzahl elektronischer Baugruppen entsprechend dem Oberbegriff von Patentanspruch 1.

Es sind zahlreiche Bauweisen zum Aufbau elektronischer Geräte bekannt. Kleinere Geräte besitzen im allgemeinen ein abgeschlossenes Gehäuse, das die elektronischen Einheiten mechanisch schützt. Bei größeren Anlagen, beispielsweise elektronische Telefon- oder Telexzentralen, werden tragende Gestelle verwendet, in die Chassis mit den elektronischen Einheiten einschiebbar sind. Im letzteren Fall wird durch die Größe des Gestells die Anzahl Chassis festgelegt, die eingeschoben werden kann. Wird diese Maximalzahl nicht erreicht, so wird im allgemeinen der freibleibende Platz durch ein Blindchassis ausgefüllt oder eine Blindplatte zum Verdecken des leeren Platzes verwendet.

Kleinere Geräte, die Zwangslüftung erfordern, besitzen eigene Ventilatoren. Bei Gestellen erfolgt die Zwangslüftung meistens durch Ventilatoren, die entweder im Gestellfuß angeordnet sind und von unten Frischluft in das Gestell blasen oder die an der oberen Abdeckung des Gestells die Warmluft absaugen. Hierbei bildet sich innerhalb des Gestells von unten nach oben ein Temperaturgradient aus, aufgrund dessen die oberen Chassis schwächer gekühlt werden als die unteren.

Aus der deutschen Offenlegungsschrift 2 638 118 ist ein zwangsbelüftetes Elektronikgestell bekannt, das diesen Nachteil vermeidet. Es weist auf seinen beiden Seiten Lüftungsrohre auf, von denen eines als Zuluft- und das andere als Abluftrohr dient. Das Zuluftrohr ist oben abgeschlossen und unten mit einem Ventilator gekoppelt, der Frischluft in das Rohr einbläst. Die Luft erreicht die einzelnen Etagen des Elektronikgestells über sogenannte Luftverteiler, welche aus Trennplatten zur luftdichten Trennung der einzelnen Etagen und aus zugeordneten Öffnungen zwischen den Etagen und den Rohren bestehen. Die Luft strömt jeweils vom Zuluftrohr durch die Öffnungen oberhalb der Trennplatten in das Innere der Etagen ein und unterhalb der Trennplatten aus dem Inneren in das Abluftrohr ab. Im Inneren der Etagen strömt die Luft von unten nach oben an den zu kühlenden Elementen vorbei. Auf diese Weise entstehen für alle Etagen die gleichen Lüftungsverhältnisse.

Für Elektronikgestelle einheitlicher Größe gibt die genannte Schrift ein befriedigendes Zwangslüftungssystem an. Für einzeln zu verwendende, kleinere elektronische Geräte bietet eine Zwangslüftung ebenfalls keine Schwierigkeit. Für elektronische Anordnungen einheitlicher Bauart, deren Größe von klein bis groß stark schwanken kann, fehlen jedoch brauchbare Angaben über die Art und Weise, wie die Forderungen nach Flexibilität, optimaler Lüftung und geringen Kosten gleichzeitig erfüllbar sind. Die Aufgabe der Erfindung besteht daher darin, derartige Angaben zu machen.

Die Erfindung, wie sie in den Ansprüchen gekennzeichnet ist, löst diese Aufgabe durch selbsttragende Stapelelemente, die übereinandergestapelt und starr miteinander verbunden ein selbsttragendes Gestell bilden. Jedes Stapelelement umfaßt Lüftungsschächte, die sich beim Übereinanderstapeln der Stapelelemente zu Lüftungsrohren zusammenfügen, die das selbsttragende Gestell umgeben und über die zwangsweise Luft dem Gestellinnern zugeführt bzw. vom Gestellinneren abgeführt werden kann.

Die Vorteile der Erfindung bestehen darin, daß durch verschieden hohes Stapeln verschieden hohe Gestelle herstellbar sind, wobei die Lüftungsverhältnisse innerhalb eines Gestells für alle Stapelelemente des Gestells unabhängig von ihrer Lage gleich sind.

Im folgenden wird die Erfindung anhand von 8 Figuren beispielsweise näher beschrieben. Es zeigt

Fig. 1 perspektivische Ansicht eines selbsttragenden Stapelelementes,

Fig. 2 perspektivische Ansicht eines unbestückten Rahmens,

Fig. 3 Beispiel eines Verbindungsstückes,

Fig. 4 Grundriß eines Stapelelementes,

Fig. 5 Seitenansicht übereinandergestapelter Stapelelemente,

Fig. 6 Strömungsplan für Kühlluft,

Fig. 7 Kombinationsmöglichkeiten von Stapeln in Aufsicht,

Fig. 8 Stapelanordnung in abgeschrägtem Raum in Seitenansicht.

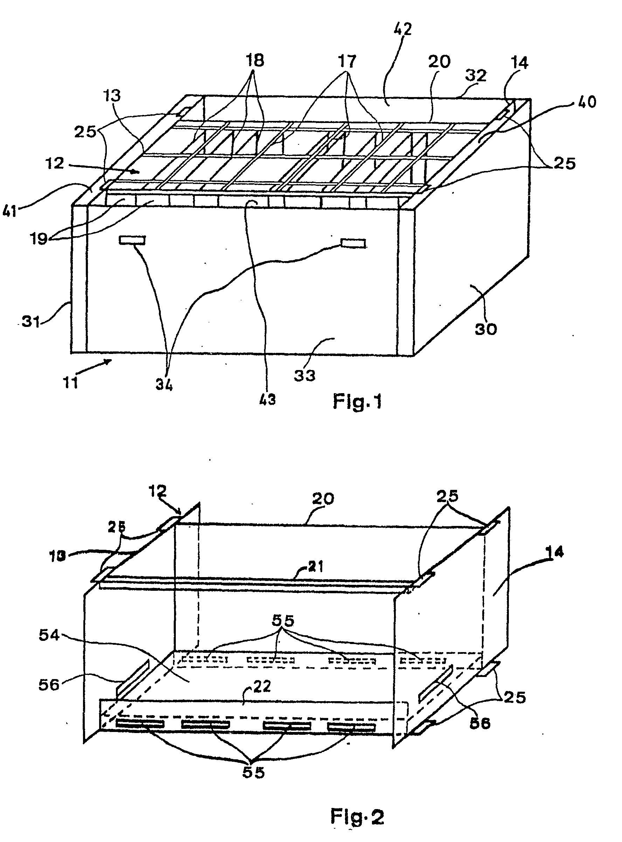

Fig. 1 zeigt die perspektivische Ansicht eines selbsttragenden Stapelelementes 11. In der Mitte des Elements befindet sich ein quaderförmiger Rahmen 12, der eine größere Zahl plattenförmiger, elektronischer Baugruppen 18 trägt. Dieser Rahmen ist der besseren Darstellung wegen in Fig. 2 nochmals gezeigt. Er wird gebildet aus einem linken Seitenblech 13 und einem rechten Seitenblech 14, die durch Leisten oder Bleche miteinander verbunden sind. Die obere, in Fig. 1 sichtbare Seite des Rahmens 12 trägt gitterförmig ausgebildete Baugruppenführungen 17. Diese decken insgesamt nur einen kleinen Teil der Fläche ab und lassen den Rest zum Zwecke der Luftventilation offen. In die Führungen 17 sowie in entsprechende, in Fig. 1 nicht sichtbare untere Führungen, sind die Baugruppen 18 aufrechtstehend von vorn einschiebbar. Die eingeschobenen Baugruppen sind hinten mit elektrischen Steckern, die auf einer Steckerträgerplatte 20 montiert sind, steckbar verbunden und werden seitlich durch die Führungen 17 gehalten. Die Steckerträgerplatte 20 kann als gedruckte Leiterplatte ausgebildet sein.

Die Baugruppen 18 besitzen Frontplatten 19, deren Gesamtheit im eingeschobenen Zustand der Baugruppen eine bis auf die Schlitze geschlossene Front bilden. Die Frontplattenbreiten sind den Bauhöhen der verwendeten Bauelemente angepaßt und entsprechen vorbestimmten Rastermassen; freie Plätze sind durch Blindplatten gefüllt.

Im bestückten Zustand besitzt der Rahmen 12 auf diese Weise vier im wesentlichen geschlossene Seiten, die gebildet werden durch die beiden Seitenbleche 13 und 14, durch die rückseitig angebrachte Steckerträgerplatte 20 und durch die Gesamtheit der Frontplatte 19, die oben durch eine Leiste 21 und unten durch eine Schlitzplatte 22 ergänzt sind.

Die obere und untere Seite ist aufgrund der gitterförmigen Ausbildung der Baugruppenführungen 17 im wesentlichen offen, was die vertikale Zu- und Abfuhr von Kühlluft zur Kühlung der Baugruppen 18 ermöglicht.

Der Rahmen 12 erhält seine Stabilität vor allem durch die Stärke der Seitenbleche 13 und 14. Am oberen und unteren Rand dieser Bleche sind Verbindungsstücke 25 angebracht, mittels derer übereinandergestapelte Elemente fest miteinander verbindbar sind, beispielsweise durch Verschrauben.

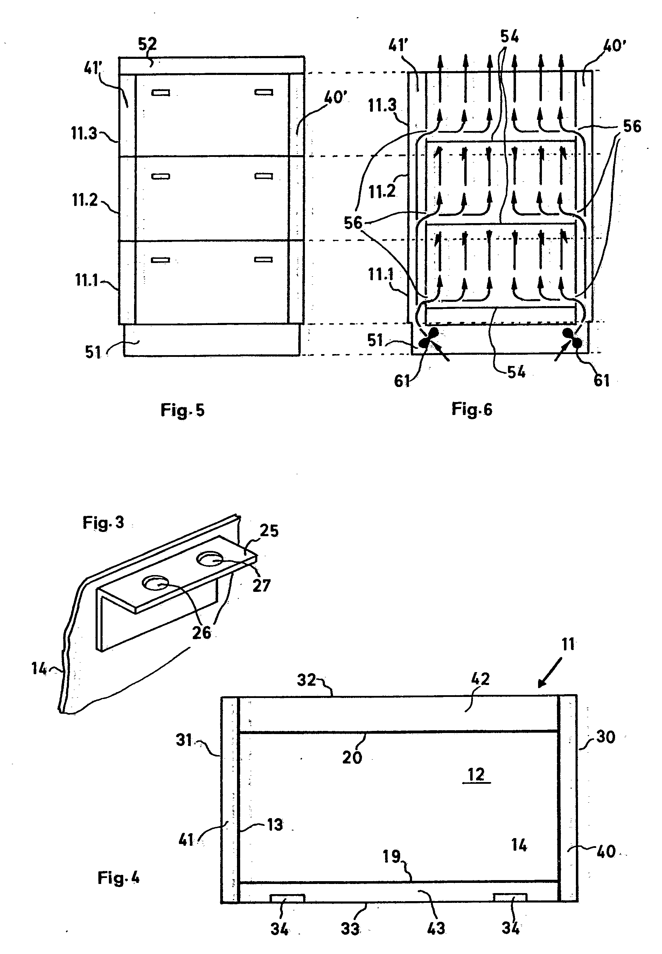

Fig. 3 zeigt einen Winkel als einfaches Beispiel für ein Verbindungsstück 25. Der Winkel ist durch Punktschweißen am Seitenblech 14 befestigt und besitzt zwei Öffnungen 26 und 27, von denen die eine beispielsweise zur Aufnahme eines Zentrierstiftes und die andere zum Verschrauben mit einem zweiten Verbindungsstück dient, das einem zweiten Rahmen 12 zugehört. In anderer Ausführung ist das Verbindungsstück 25 durch Stanz- und Biegeprozesse direkt aus dem Seitenblech 14 gewinnbar. Der anhand von Fig. 1 und 2 beschriebene quaderförmige Rahmen 12 bildet zusammen mit Verkleidungsblechen 30, 31, 32 und 33 ein Stapelelement 11.

Fig. 4 zeigt ein Stapelelement 11 in Grundrißdarstellung. Die Verkleidungsbleche 30 bis 33 sind so angebracht, daß das Blech 30 zusammen mit dem Seitenblech 14 einen rechteckigen Querschnitt bildet, daß das Blech 31 mit dem Seitenblech 13 einen entsprechenden Querschnitt bildet, und daß das Blech 32 zusammen mit den hinteren Enden der Seitenbleche 13 und 14 sowie mit der Steckerträgerplatte 20 ebenfalls einen rechteckigen Querschnitt bildet. Die Verkleidungsbleche 30, 31 und 32 sind mit den Seitenblechen 13 und 14 starr verbunden. Die rechteckigen Querschnitte bilden somit die Querschnitte von rohrförmigen, oben und unten offenen Gebilden, die im folgenden als Lüftungsschächte 40, 41 und 42 bezeichnet werden.

Das Verkleidungsblech 33, in dem zwei Griffe 34 angebracht sind, ist abnehmbar. Es bildet im eingebauten Zustand zusammen mit den vorderen Enden der Seitenbleche 13 und 14 sowie mit der Gesamtheit der Frontplatten 19 einen vierten Lüftungsschacht 43, der ebenfalls oben und unten offen ist. Das Stapelelement 11 bildet damit eine quaderförmige Einheit aus dem zentralen Rahmen 12, und ihn umgebenden Lüftungsschächten 40, 41, 42, 43, wobei die obere und untere Begrenzungsfläche des Stapelelements im wesentlichen offen sind.

Fig. 5 zeigt in Aufrißdarstellung die Kombination mehrerer Stapelelemente 11. Diese Elemente sind übereinandergestapelt und mittels der oben beschriebenen Verbindungsstücke 25 starr miteinander verbunden. Die Verbindungsfugen sind durch Dichtungen, die beispielsweise die Form eines H-Profils aufweisen, abgedichtet. Der so gebildete Stapel steht auf einem Fußteil 51, der eine nicht gezeigte Nivelliereinrichtung enthält, mittels der der Stapel unabhängig von der Bodenbeschaffenheit senkrecht ausrichtbar ist. Oben ist der Stapel durch ein Kopfteil 52 abgedeckt.

Die oben und unten offenen Lüftungsschächte der Stapelelemente 11.1 bis 11.3 bilden zusammen vertikale Lüftungsrohre, die wie folgt für Lüftungszwecke verwendet werden: Das rechte und linke Rohr 40' bzw. 41' dienen zur Frischluftzufuhr. Das hintere und vordere Rohr 42' bzw. 43' führen die Abluft fort. Jeder Rahmen 12 wird durch eine etwa gleiche Menge Frischluft versorgt, unabhängig von seiner Lage im Stapel.

Jeder Rahmen 12 besitzt zur Trennung der kalten und warmen Kühlluft eine Trennplatte 54. In Fig. 2 ist die Trennplatte 54 teils ausgezogen und teils gestrichelt gezeichnet. Es handelt sich um ein dünnes Blech, das in etwa drei Zentimeter Abstand unterhalb der unteren Baugruppenführung 17 im Rahmen angeordnet ist. Es unterteilt den Rahmen 12 in einen großen oberen und einen kleinen unteren Bereich.

Zur Verbindung der Lüftungsschächte 40, 41, 42, 43 mit dem Inneren des Rahmens 12 weisen dessen Seitenwände Öffnungen auf. Diese sind vorn und hinten unterhalb der Trennplatte 54 angeordnet, während die rechts und links in den Seitenblechen 14 bzw. 13 angebrachten Öffnungen 56 oberhalb der Trennplatte 54 liegen. Die zur Kühlung eines Stapelgestells dienende Kühlluft tritt, über das rechte und linke Lüftungsrohr 40' und 41' kommend, durch die Öffnungen 56 oberhalb der Trennplatte 54 und unterhalb der Baugruppe 18 ein. Sie strömt zwischen den Leiterplatten nach oben, erwärmt sich und führt die Wärme über die Öffnungen 55 des nächsthöheren Rahmens 12 an das vordere bzw. hintere Lüftungsrohr 42' bzw. 43' ab.

Fig. 6 verdeutlicht dieses Verhalten anhand eines Strömungsplanes. Danach wird über zwei Ventilatoren 61, die im Fußteil 51 angeordnet sind, dauernd von unten Frischluft in die zuoberst geschlossenen Lüftungsrohre 40' und 41' gedrückt. Aus diesen Rohren strömt durch die Öffnungen 56 in jeden Rahmen 12 von rechts und links ständig Frischluft ein. Innerhalb jedes Rahmens strömt die Luft zwischen den Baugruppen nach oben und tritt über die Öffnungen 55 des nächst höheren Elements nach vorne und nach hinten aus, was durch scharf abgeknickte Pfeile angedeutet ist. Aus dem obersten Element 11 kann die Luft ungestört nach oben entweichen, sofern nicht ein Kopfteil 52 für seitlichen Austritt sorgt.

Die Querschnitte der Öffnungen 55 und 56 jedes Stapelelements sind kleiner als die Querschnitte der Lüftungsrohre 40' bis 43' und auf diese sowie die Stärke und Anzahl der Ventilatoren 61 so abgestimmt, daß in den Rohren 40' und 41' stets ein so hoher Überdruck herrscht, daß unabhängig von der Lage des Stapelelements jedes Stapelelement etwa die gleiche Menge Frischluft erhält. Hierdurch wird erreicht, daß alle Baugruppen 18 eines Stapels etwa den gleichen Kühlbedingungen unterliegen.

Die vordere Verkleidungsplatte 33 eines Stapelelements 11 ist, wie bereits erwähnt, abnehmbar ausgebildet. Im abgenommenen Zustand sind die Frontplatten 19 der Baugruppen 18 sichtbar. Die Baugruppen sind nun nach vorne herausziehbar. Sind alle Baugruppen herausgezogen, so kann weiter die Steckerträgerplatte 20 abgeschraubt und nach vorne herausgehoben werden. Hierdurch wird der hintere Lüftungsschacht 42 bzw. das entsprechende Lüftungsrohr zugänglich. In diesem Rohr sind die Verbindungskabel zwischen den einzelnen Stapelelementen 11, bevorzugt als Flachbandkabel ausgebildet, untergebracht. Diese Kabel sind nach dem beschriebenen Entfernen der Steckerträgerplatte 20 zugänglich. Damit können sämtliche elektrischen Bestandteile eines Stapels bzw. des beschriebenen Elektronikgestells von vorne erreicht werden.

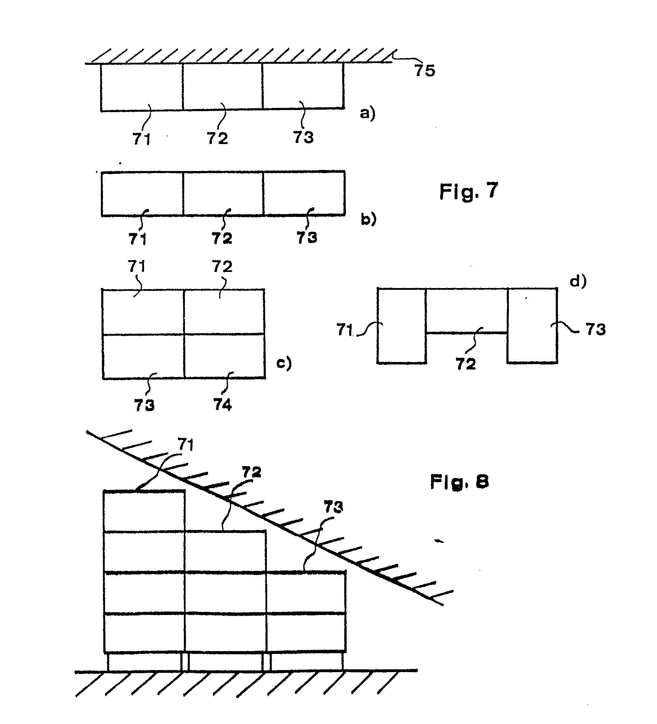

Diese letztgeschilderte Eigenschaft ermöglicht die Aufstellung der Elektronikgestelle in weitgehend freier Anordnung. Fig. 7 zeigt hierfür einige Beispiele in Grundrißdarstellung. Nach Fig. 7a können mehrere Elektronikgestelle, beispielsweise die drei Gestelle 71, 72 und 73 an einer Wand 75 aufgestellt sein. Fig. 7b zeigt eine entsprechende Anordnung als freistehende Gestellreihe. Nach Fig. 7c und 7d ist weiter die Anordnung Rücken gegen Rücken und als Block möglich. Fig. 8 zeigt schließlich, von vorne gesehen, die Anordnung dreier verschieden hoher Gestelle 71, 72 und 73 in einem abgeschrägten Raum.

Der Vorteil der Erfindung besteht offensichtlich darin, daß die Stapelelemente 11 sehr flexibel kombinierbar sind, wobei durch das Lüftungskonzept bei jeder Kombination gleich gute Lüftungsverhältnisse erreichbar sind. Die kombinierten Stapelelemente 11 bilden selbsttragende Gestelle, die separate, tragende Einheiten erübrigen. Die Stapel bilden damit Elektronikgestelle, die bei geringerem Preis höhere Flexibilität bieten.

Die Erfindung erlaubt eine große Anzahl von Ausführungsvarianten. So sind die geometrischen Abmessungen frei variierbar. Die Lüftungsrohre 40' bis 43' können einen nicht rechteckigen Querschnitt aufweisen. Die von den Stapelelementen 11 unabhängigen Ventilatoren 61 können an beliebigen Stellen Luft in die Rohre 40' und 41' blasen. Die Trennplatte 54 kann V-förmig gebogen sein, so daß die erwärmte Luft, von den Baugruppen 18 kommend, zwangsweise aufgeteilt wird in Luft, die zum vorderen und Luft die zum hinteren Rohr führt. Diese Aufteilung kann so sein, daß die Luftmengen den Querschnitten der Rohre 42' und 43' entsprechen.

Die an den Vorderseiten der Stapelelemente 11 angebrachten Verkleidungsplatten 33 sind, wie erwähnt, abnehmbar. Soll die im Elektronikgestell untergebrachte elektronische Anordnung Unberechtigten nicht zugänglich sein, so empfiehlt es sich, die Platten 33 verschließbar zu machen. Vorteilhaft ist es, wenn für ein vollständiges Gestell nur ein Schloß benötigt wird. Hierzu kann vorgesehen werden, daß über ein steckbares System von beispielsweise Vierkant-Stangen, an denen Verschlußhebel befestigt sind, eine Gesamtverschluß-Stange beim Übereinanderstapeln der Stapelelemente 11 entsteht, die gemeinsam über eine einzige Betätigungsvorrichtung drehbar und abschließbar ist.

**Patentansprüche**

1. Etagenweise aufgeteiltes, mit einem Zwangslüftungssystem ausgestattetes Elektronikgestell (Fig. 5 und 6) zur Aufnahme einer Vielzahl plattenförmiger, elektronischer Baugruppen (18), die aufrecht stehend von vorne in das Gestell einschiebbar sind, die in vollständig eingeschobenem Zustand, gehalten durch luftdurchlässige Führungen (17), rückseitige über Steckverbinder elektrisch miteinander verbunden sind und die mit ihren Frontplatten (19) eine bis auf dünne Schlitze geschlossene Front bilden, wobei sich das Zwangsbelüftungssystem zusammensetzt aus Zu- und Abluftrohren (40', 41'), welche vertikal an den Seiten des Gestells angeordnet sind, aus Trennplatten (54), die die verschiedenen Etagen des Gestells luftdicht gegeneinander abgrenzen, aus Luftein- und Luftaustrittsöffnungen (56, 55) ober- bzw. unterhalb der Trennplatten (54) zur Verbindung der Zu- bzw. Abluftrohre (40', 41') mit den Etagen und aus Ventilatoren (61) zum Einspeisen von Frischluft in die an den Enden geschlossenen Zuluftrohre, gekennzeichnet durch folgende Merkmale:

a) das Elektronikgestell (Fig. 5) setzt sich zusammen aus unabhängigen, selbsttragenden Stapelelementen (11), die frei übereinander gestapelt auf einem Fußteil (51) stehen und die untereinander und mit dem Fußteil starr verbunden sind;

b) jedes Stapelelement (11) bildet eine Einheit aus einem inneren, oben und unten offenen Rahmen (12), welcher durch eine Trennplatte (54) luftdicht in einen oberen und einen ungleich großen unteren Bereich geteilt wird, von denen der größere zur Aufnahme der Baugruppen (18) dient, und aus drei vertikalen Lüftungsschächten (40, 41, 42), die den mit Verbindungsöffnungen (55, 56) versehenen Rahmen (12) an der linken, rechten und rückwärtigen Seite umgeben, und die sich beim Übereinanderstapeln der Stapelelemente (11) zu den Lüftungsrohren (40', 41', 42') zusammenfügen.

2. Elektronikgestell nach Anspruch 1, gekennzeichnet durch folgende Merkmale:

c) die linke und rechte Seitenwand des Rahmens (12) werden aus ebenen Blechen (13, 14) gebildet, die über die Breite des Rahmens (12) hinausreichen, die die tragenden Elemente der Stapelelemente (11) bilden und an denen Verbindungsstücke (25) zur Verbindung mit anderen Stapelelementen (11) angebracht sind;

d) die Rückwand des Rahmens (12) wird aus einer Steckerträgerplatte (20), die die elektrischen Steckverbinder trägt, gebildet;

e) die Vorderwand des Rahmens (12) wird im bestückten Zustand durch die Frontplatten (19) der eingeschobenen Baugruppen (18), durch eine Leiste (21) und durch eine Schlitzplatte (22) gebildet, die zusammen die Vorderseite vollständig abdecken;

f) die Trennplatte (54) ist unterhalb der unteren Baugruppenführung (17) angebracht, und

g) die Lüftungsschächte (40, 41, 42) besitzen rechteckigen Querschnitt und sind aus nichttragendem Material gebildet, welches starr mit den tragenden Blechen (13, 14) verbunden ist.

3. Elektronikgestell nach Anspruch 1, gekennzeichnet durch folgende Merkmale:

h) die neben der linken und rechten Seite der Rahmen (12) angeordneten Lüftungsrohre (40', 41') bilden die Zuluftrohre, die oben durch ein Kopfteil (52) luftdicht abgeschlossen sind;

i) das an der Rückseite der Rahmen (12) angeordnete Lüftungsrohr (42') bildet ein oben offenes Abluftrohr, und

j) die Ventilatoren (61) sind im Fußteil (51) untergebracht.

4. Elektronikgestell nach Anspruch 1, gekennzeichnet durch folgendes Merkmal:

k) vor den Frontplatten (19) der Baugruppen (18) ist in jedem Stapelelement (11) zwischen den vorgezogenen tragenden Blechen (13, 14) eine mit Griffen (34) versehene Verkleidungsplatte (33) einhängbar, welche zusammen mit den Frontplatten (19) und den tragenden Blechen (13, 14) ein viertes, als Abluftrohr dienendes Lüftungsrohr (43') formen.

**Claims**

1. Tier-type forced-draught ventilated rack (Fig. 5 and 6) for mounting printed circuit boards, which are insertable into the rack from the front, which are positioned upright in ventilable channels (17) and which are electrically interconnected via plug connectors at the rear and whose front plates (19) form a closed front, except for narrow slots, the forced-draught ventilation system consisting of supply and exhaust pipes (40', 41') arranged vertically along the sides of the rack, of divider plates (54) forming air seals between the various tiers, of air inlet and exit openings (56, 55) above and below the divider plates (54), respectively, for interconnecting the supply and exhaust pipes (40', 41'), respectively, with the tiers, and of ventilators (61) supplying fresh air to the supply pipes (40') whose ends are closed, characterized by the following features:

a) The rack (Fig. 5) is assembled of independent, self-supporting stack-elements (11) which are stacked one above the other and positioned on a base (51) and which are rigidly connected to each other and to the base;

b) each stack-element (11) forms a unit, consisting of an inner frame (12), open towards the top and the bottom, subdivided air-tightly into an upper and a lower section of unequal size by a divider plate (54) the larger section being used for mounting the printed circuit boards (18), and consisting of three vertically arranged venting ducts (40, 41, 42) which surround the frame (12) being provided with inlet and outlet openings (55, 56), at the left-hand, at the right-hand and at the rear sides, and which, when stacking the stack-elements (11) join together to the supply and exhaust pipes (40', 41', 42').

2. Ventilated rack, according to claim 1, characterized by the following features:

c) The left-hand and the right-hand side panel of the frame (12) consist of flat metal support elements (13, 14) extending beyond the width of the frame (12), constituting the supports of the stack-elements (11) and to which connecting units (25) are attached for mechanical interconnection with other stack-elements;

d) the rear panel of the frame (12) is designed as a connector support panel (20) which supports the plug connectors;

e) when the rack holds printed circuit boards (18), the front panel of the frame (12) is formed by the front plates (19) of the inserted boards (18), by a strip (21) and by a slotted panel (22), which together cover the whole front;

f)    the divider plate (54) is mounted below the lower ventilable channels (17), and

g)    the venting ducts (40, 41, 42) have a rectangular cross section, and are formed by non-supporting material rigidly connected to the support elements (13, 14).

3. Ventilated rack, according to claim 1, characterized by the following features:

h)    The ventilation pipes (40', 41') arranged on the left-hand and the right-hand sides of the frame (12) form the supply pipes being sealed tightly at the top by a terminating element (52);

i)    the ventilation pipe (42') at the rear side of the frame (12) forms an exhaust pipe open at the top, and

j)    the ventilators (61) are installed in the base (51).

4. Ventilated rack according to claim 1, characterized by the following feature:

k)    In front of the front plates (19) of the printed circuit boards (18), a face plate (33) with handles (34) can be hooked between the extending support elements (13, 14) of each stack-element (11), the face plates (33), the front plates (19) and the support elements (13, 14) forming together a fourth ventilation pipe (43') serving as exhaust pipe.

## Revendications

1. Baie en étagères avec aération forcée (Fig. 5 et 6), destinée à recevoir une pluralité de groupes d'assemblage électroniques (18) en forme de plaques, qui sont insérables de face dans le baie en position verticale, qui sont tenus, à l'état totalement inséré, par des glissières (17), perméables à l'air, et qui sont reliés électriquement entre eux à l'arrière au moyen de raccordements de prises, et qui forment, grâce à leurs plaques frontales, une surface fermée, à l'exception de fentes minces, près de quoi le système d'aération forcée se compose de tuyaux d'amenée et d'évacuation d'air (40', 41'), placés verticalement sur les côtés de baie, de plaques de séparation (54) qui imperméablement séparent les différents étages des baies, d'ouvertures d'entrée et de sortie (56, 55) pour jonction entre les tuyaux (40', 41') et les étages situées au-dessus et au-dessous des plaques des séparation (54), et de ventilateurs (61) qui insufflent de l'air frais dans les tuyaux d'amenée dont les extrémités sont fermés, caractérisé par les caractéristiques suivantes:

a)    le baie (Fig. 5) se compose d'éléments emboîtées, indépendants et autoporteurs (11), reposant librement l'un sur les autres sur un élément de base (51), reliés entre eux et avec l'élément de base;

b)    chaque élément emboîté (11) forme une unité comprenant un cadre intérieur (12) ouvert vers le haut et vers le bas, lequel est imperméablement divisé par une plaque de séparation (54) en une partie supérieure et en une partie inférieure de dimensions inégales, la plus grande partie servant à recevoir les groupes d'assemblage (18), et comprenant de trois conduits d'aération (40, 41, 42), qui entourent le cadre (12), muni d'ouvertures de raccordement (55, 56), sur les côtés gauche, droit et arrière.

2. Baie pour éléments électroniques selon la revendication 1, caractérisé par les caractéristiques suivantes:

c)    les parois latérales gauche et droite du cadre (12) sont formées de tôles plates (13, 14), dépassant la largeur du cadre (12) et formant les éléments porteurs des éléments emboîtés (11), et y sont fixée des pièces de raccordement (25) permettant le raccord avec d'autres éléments amboîtés (11);

d)    la paroi arrière du cadre (12) est constituée par une plaque de support de prises (20) portant les connexions électriques;

e)    la paroi frontale du cadre (12) est constituée, à l'état monté, par des plaques frontales (19) appartenant aux groupes d'assemblage (18) insérés, par d'un tringle (21) et d'une plaque à fentes (22), recouvrant ensemble la totalité de la partie avant;

f)    la plaque de séparation (54) est fixée en-dessous de la glissière inférieure (17), et

g)    les conduits d'aération (40, 41, 42) ont une section rectangulaire et sont formés de matériaux non porteurs reliés fixement avec les tôles porteuses (13, 14).

3. Baie pour éléments électroniques selon la revendication 1, caractérisé par les caractéristiques suivantes:

h)    les tuyaux d'aération (40', 41') disposés à côté des parois gauche et droite des cadres (12) forment les tuyaux d'amenée, étant fermés en haut par une pièce faîtière (52);

i)    le tuyau d'aération (42') disposé au dos des cadres (12) constitue un tyau d'évacuation d'air ouvert vers le haut, et

j)    les ventilateurs (61) sont logés dans l'élément de base (51).

4. Baie pour éléments électroniques selon la revendication 1, caractérisé par la caractéristique suivante:

k)    une plaque de revêtement (33) munie de poignées (34) peut être accrochée, dans chaque élément emboîté (11), devant les plaques frontales (19) des groupes d'assemblage (18) et entre les tôles portantes (13, 14), qui forme, avec les plaques frontales (19) et les tôles (13, 14), un quatrième tuyau d'aération (43'), servant de tuyau d'évacuation.

Fig.1

Fig.2

Fig. 5          Fig. 6

Fig. 3

Fig. 4

a)

71  72  73

Fig. 7

b)

71  72  73

71  72

d)

71  72  73

c)

73  74

71  72  73

Fig. 8